# FASCICULE DE BREVET EUROPEEN

(11) **EP 0 498 703 B1**
(45) Date de publication et mention de la délivrance du brevet: **16.09.1998**
(21) Numéro de dépôt: 92400260.3
(22) Date de dépôt: 31.01.1992
(51) Int. Cl.: H01L 21/58, H01L 21/68, H01L 21/98

(54) **Procédé et dispositif d'insertion de puces dans des logements d'un substrat par tête d'encollage**
Verfahren und Vorrichtung zum Einsetzen von Chips in Substrataufnahmeplätze mittels eines Einklebekopfes
Process and device to place chips into receptacles provided in a substrate using an adhesive

(30) Priorité: 04.02.1991 FR 9101233
(43) Date de publication de la demande: 12.08.1992
(73) Titulaire: FRANCE TELECOM, 75015 Paris (FR)
(72) Inventeur: Schiltz, André, F-38330 Saint-Ismier (FR); Thevenot, Louis, F-38240 Meylan (FR); Vareille, Aimé, F-38130 Echirolles (FR)
(74) Mandataire: Casalonga, Axel

(56) Documents cités:
- PATENT ABSTRACTS OF JAPAN vol. 10, no. 386 (E-467)(2443) 24 Décembre 1986 & JP-A-61 177 731 ( TOSHIBA CORP ) 9 Août 1986
- PATENT ABSTRACTS OF JAPAN vol. 11, no. 41 (E-478)(2488) 6 Février 1987 & JP-A-61 207 024 ( OKI ELECTRIC CO LTD ) 13 Septembre 1986
- PATENT ABSTRACTS OF JAPAN vol. 6, no. 140 (E-121)(1018) 29 Juillet 1982 & JP-A-57 063 835 ( SHINKAWA SEISAKUSHO KK ) 17 Avril 1982
- PATENT ABSTRACTS OF JAPAN vol. 8, no. 217 (E-270)(1654) 4 Octobre 1984 & JP-A-59 100 545 ( MATSUSHITA DENKO KK ) 9 Juin 1984
- PATENT ABSTRACTS OF JAPAN vol. 6, no. 52 (E-100)(930) 7 Avril 1982 & JP-A-56 164 544 ( HITACHI ) 17 Décembre 1981

## Description

La présente invention concerne le report de puces sur substrats notamment du type hybride multicouches et plus particulièrement les techniques d'insertion d'une ou de plusieurs puces ou composants électriques ou électroniques dans des logements ménagés dans un substrat.

Les progrès effectués ces dernières années dans le domaine de la conception et de la réalisation de circuits intégrés ou puces ont permis de miniaturiser considérablement ces composants. Aujourd'hui, les possibilités de réduction de la taille des puces se trouvent limitées. On cherche donc depuis quelques années à réduire les distances entre composants associés afin de miniaturiser voire transformer les circuits imprimés classiques en vue de la fabrication de ce que l'on appelle parfois des "superpuces" qui sont constituées de puces reportées sur des réseaux multicouches d'interconnexion de petites dimensions.

Pour effectuer le report de puces nues directement rapportées sur un substrat, on connaît aujourd'hui principalement trois méthodes.

La première consiste à coller la puce sur le substrat puis à interconnecter la puce et le réseau du substrat grâce à des fils métalliques soudés. Les inconvénients de cette technique de liaison classique par fils résultent de la fragilité des fils et de la soudure fil-plot ainsi que de l'encombrement d'une telle structure.

Une seconde technique dite de "flip-chip" permet de souder directement les plots de la puce aux plots du substrat, la puce étant posée ou collée sur le substrat. Les inconvénients de cette technique résident d'une part dans la difficulté d'aligner à l'envers les plots de la puce et ceux du substrat et d'autre part dans la difficulté de réaliser la soudure des différents plots sans engendrer de contraintes mécaniques.

Une troisième technique consiste à introduire les puces nues dans respectivement des logements préalablement exécutés dans le substrat, à les coller et à connecter les plots des puces aux plots du substrat par la réalisation à l'aide d'outils microlithographiques de chemins électroconducteurs de surface.

Dans une première variante proposée, le substrat qui comporte le réseau d'interconnexion et les logements destinés ultérieurement à l'insertion des puces est collé sur un deuxième substrat plan.

Dans une deuxième variante proposée, on utilise un substrat plan de référence sur lequel on applique un feuillard d'aluminium recouvert d'un agent de démoulage du type polytétrafluoréthylène puis on plaque chaque puce à l'aide d'un clip de serrage et on dépose la colle de fixation des puces au substrat en face arrière de ces derniers, l'ensemble étant, après collage des puces, démoulé et les plots des puces et du substrat étant reliés par métallisation.

Les inconvénients des techniques d'insertion ci-dessus sont les suivants. Dans les deux variantes proposées, l'espace entre les puces et le substrat est relativement large, ce qui conduit à un certain désalignement et à une difficulté de centrage des puces dans leur logement. La colle de scellement est déposée de manière peu précise, ce qui laisse une tranchée en face arrière du substrat, qui génère des problèmes d'isolation thermique et des problèmes de planéité et de remplissage lors de l'étape de littrographie des contacts interplots. Dans la première variante proposée, le substrat supplémentaire ajouté de manière permanente empêche une bonne dissipation thermique en face arrière du substrat et des puces et empêche toute réparation ultérieure. Dans la seconde variante proposée, la nécessité d'utiliser un clip de serrage par puce à reporter sur un substrat engendre un encombrement tel que le report de plusieurs puces paraît fastidieux.

Le but de la présente invention est de proposer un procédé et des moyens d'insertion de puces dans des logements ménagés dans un substrat qui ne présentent pas les inconvénients des méthodes connues.

Selon un objet de l'invention, le procédé d'insertion consiste à engager dans un logement du substrat, une tête d'encollage dimensionnée de telle sorte qu'il subsiste entre elle et la paroi du logement un espace, à déposer grâce à cette tête d'encollage de la matière de scellement contre la paroi du logement précité, à retirer la tête d'encollage, et à placer dans le logement une puce de telle sorte que la matière de scellement déposée contre la paroi du logement remplisse au moins en partie l'espace entre cette paroi et la paroi périphérique de la puce et que, après durcissement de la matière de scellement, la puce soit fixée au substrat dans le logement.

Selon une variante de l'invention, le procédé consiste à enduire de matière de scellement la face périphérique de la tête d'encollage avant de l'introduire dans le logement par trempage.

Selon une autre variante, le procédé de l'invention consiste à injecter la matière de scellement dans l'espace entre la paroi du logement et la tête d'encollage au travers de cette dernière.

Selon l'invention, le durcissement de la matière de scellement peut notamment être obtenu par traitement thermique ou par photoréticulation.

Selon l'invention, le procédé peut avantageusement consister, grâce à plusieurs têtes d'encollage mobiles simultanément et/ou plusieurs têtes d'insertion, à effectuer les opérations précitées afin de sceller simultanément plusieurs puces dans respectivement plusieurs logements du substrat.

Selon l'invention, ladite tête peut avantageusement être dimensionnée de telle sorte qu'il subsiste entre les flancs droits du logement et sa paroi périphérique un espace d'épaisseur comprise entre 20 et 100 microns.

Selon l'invention, la partie périphérique de ladite tête d'encollage peut avantageusement présenter une épaisseur égale ou inférieure à la partie du substrat entourant le logement précité.

Selon l'invention, ladite tête d'encollage peut avantageusement comprendre au moins un canal d'amenée de matière de scellement débouchant à sa périphérie.

Selon l'invention, ladite tête d'encollage peut être telle qu'au moins sa partie périphérique soit en un matériau poreux.

La présente invention a également pour objet un dispositif d'insertion de puces dans des logements d'insertion ménagés dans un substrat notamment du type hybride.

Ce dispositif comprend de préférence une tête d'encollage pour déposer de la matière de scellement contre la paroi d'un logement du substrat, des moyens pour déplacer cette tête d'encollage, une tête d'insertion adaptée pour engager une puce dans le logement du substrat et la maintenir, et des moyens pour déplacer cette tête d'insertion.

Dans une variante, le dispositif de l'invention peut comprendre plusieurs têtes d'encollage et des moyens pour déplacer simultanément ces têtes afin de déposer de la matière de scellement simultanément contre la paroi de plusieurs logements du substrat, plusieurs têtes d'insertion et des moyens pour déplacer simultanément ces têtes afin d'engager et maintenir simultanément plusieurs puces dans plusieurs logements du substrat.

Selon l'invention, le dispositif peut en outre comprendre des moyens pour provoquer le durcissement de la matière de scellement entre la puce insérée et la paroi du logement.

Selon l'invention, ladite tête d'insertion peut avantageusement comprendre des moyens pour transférer et maintenir la puce par succion.

La présente invention sera mieux comprise à l'étude de procédés et dispositifs de report de puces ou autres composants électriques ou électroniques dans des logements ménagés dans des substrats, mettant en oeuvre des têtes d'encollage, décrits à titres d'exemples non limitatifs et illustrés par le dessin sur lequel :
- les figures 1 à 5 représentent successivement les différentes étapes d'un procédé selon l'invention, en vue de l'insertion d'une puce dans un logement ménagé au travers d'un substrat représenté en coupe verticale, mettant en oeuvre une première tête d'encollage ;
- la figure 6 représente une coupe selon IV-VI du substrat représenté sur la figure 5 ;
- la figure 7 représente une autre tête d'encollage à son étape du procédé ci-dessus correspondant à la figure 3 ;
- la figure 8 représente une autre tête d'encollage à son étape du procédé ci-dessus correspondant à la figure 3 .
- la figure 9 représente un procédé selon l'invention mettant en oeuvre plusieurs têtes d'encollage ;
- la figure 10 représente un procédé selon l'invention mettant en oeuvre plusieurs moyens d'insertion de puces ;
- et la figure 11 représente un dispositif ou machine destinée à l'encollage et à l'insertion de puces dans un substrat.

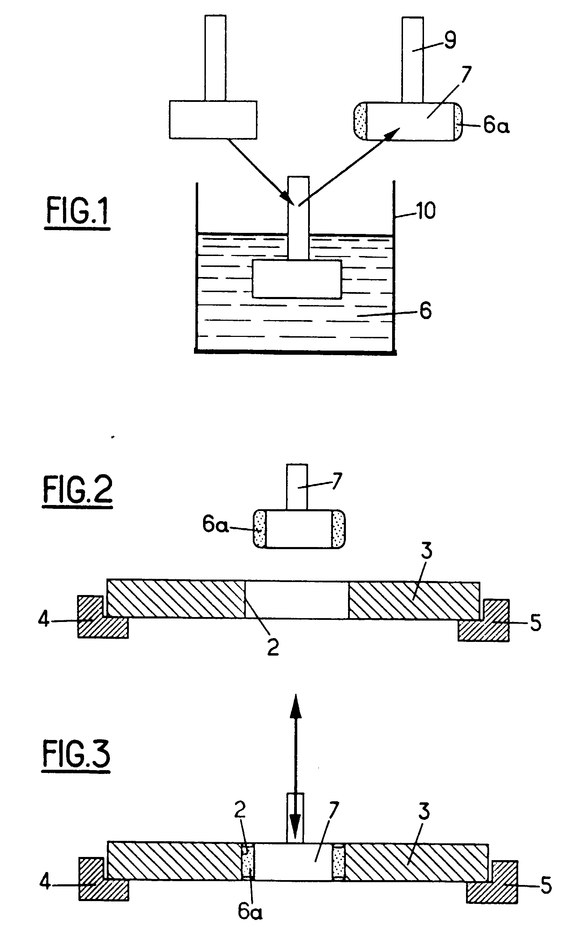

En se reportant aux figures 1 à 6, on va tout d'abord décrire un procédé d'insertion d'une puce 1 dans un logement 2 à flancs droits ménagés au travers d'un substrat 3 en forme de plaque rectangulaire disposée horizontalement et dont deux bords opposés sont en appui sur des supports 4 et 5, à distance du logement 2. Dans l'exemple, le logement est de section rectangulaire et la puce 1 est de forme parallélipipédique et présente une section correspondante.

Le procédé représenté permet, dans un premier temps, de déposer une matière de scellement liquide 6 telle qu'une colle du type époxy ou du type acrylique contre la paroi périphérique du logement 2 à l'aide d'une tête d'encollage 7 et, dans un second temps, de placer dans le logement 2 la puce 1 à l'aide d'une tête d'insertion 8. Cette matière de scellement présente de préférence une viscosité comprise entre 10 et 10 000 centipoises.

Comme on le voit sur les figures 1 à 3, la tête d'encollage 7 est constituée par un bloc parallélipipédique de section correspondant à celui de la puce 1 et d'épaisseur égale, mais de préférence inférieure, à l'épaisseur du substrat 3, cette tête étant portée par l'extrémité inférieure d'une tige verticale de manoeuvre 9.

Comme on le voit sur la figure 1, une première étape du procédé d'encollage consiste à plonger la tête d'insertion 7 dans un réservoir 10 contenant la matière de scellement 6 et à la ressortir, de telle sorte qu'il subsiste contre la surface périphérique de cette tête d'encollage 7 de la matière de scellement 6a.

Dans une seconde étape représentée sur la figure 2, le procédé consiste à amener la tête d'encollage 7 au-dessus et à la verticale du logement 2 du substrat 3.

Dans une troisième étape représentée sur la figure 3, le procédé consiste à engager la tête d'encollage dans le logement du substrat 3 de telle sorte que la matière de scellement 6a qu'elle porte s'étale par capillarité et mouille complètement la paroi du logement 2, et à retirer la tête d'encollage 7. Ainsi, la matière de scellement 6a est transférée de la surface périphérique de la tête d'encollage 7 à la paroi périphérique du logement 2 du substrat 3.

De préférence, l'épaisseur de la partie périphérique de la tête d'encollage 7 est égal ou inférieur à l'épaisseur de la partie du substrat 3 entourant son logement 2 et l'espace annulaire subsistant entre la face périphérique de la tête d'encollage 7 et la paroi périphérique du logement 2 lorsqu'elle y est insérée présente une épaisseur comprise entre vingt et cent microns. De préférence, l'épaisseur moyenne de la lame de matière de collage déposée par trempage contre la face périphérique de la tête d'encollage 7 est sensiblement égale à l'épaisseur de cet espace annulaire.

Ainsi, le transfert précité de la matière de scellement peut se produire sans que la matière de scellement 6a ne se dépose ou ne vienne mouiller la surface du substrat 3 autour du logement 2.

Il convient en fait de choisir l'épaisseur de la partie périphérique de la tête d'encollage 7 et l'épaisseur de l'espace annulaire précité de telle sorte que la quantité de matière de scellement désirée soit déposée contre la paroi périphérique du logement du substrat.

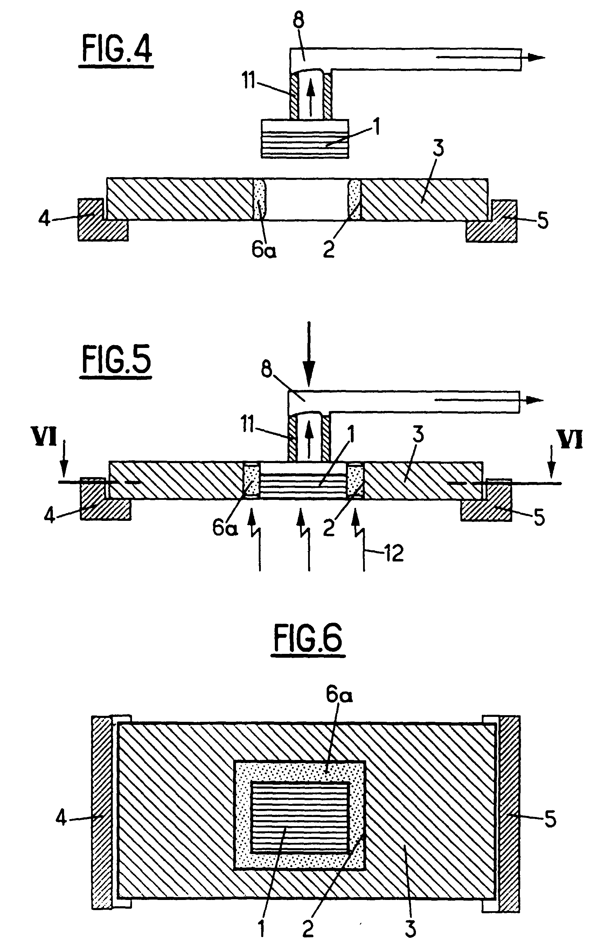

En se reportant maintenant aux figures 4 et 5, on voit que la tête d'insertion 8 comprend un tube d'aspiration 11 mobile verticalement qui porte à son extrémité inférieure, par succion, la puce 1 en prenant appui sur sa face supérieure.

Dans une première étape du procédé représenté sur la figure 4, on déplace la tête d'insertion 8 de manière à amener la puce 1 au-dessus et a la verticale du logement 2 du substrat 3 encollé de la matière de scellement 6a.

Dans une seconde étape représentée sur la figure 5, on déplace la tête d'insertion 8 de manière à engager la puce 1 dans le logement 2 du substrat 3. Dans cette position engagée, il subsiste un espace annulaire entre la face périphérique de la puce 1 et la paroi périphérique du logement 2 tel que la matière de scellement 6a s'étale par capillarité et mouille complètement l'espace compris entre la surface périphérique de la puce 1 et la paroi périphérique du logement 2.

Grâce à un moyen adapté pour provoquer le durcissement de la matière de scellement 6a, constitué par un moyen de chauffage ou par un rayonnement ultraviolet 12 comme représenté sur la figure 5, on provoque le durcissement de la matière de scellement 6a, puis on retire la tête d'insertion 8 qui tenait la puce 1. La puce 1 est alors insérée et fixée dans le logement 2 du substrat 3.

De préférence, l'épaisseur de la partie périphérique de la puce 1 est égale ou inférieure à l'épaisseur du substrat 3, de manière à pouvoir être complètement insérée dans son logement 2 lors de son installation grâce à la tête d'insertion 8. En outre, l'espace annulaire séparant la face périphérique de la puce 1 et la paroi périphérique du logement 2 du substrat 3 présente une épaisseur comprise entre vingt et cent microns.

On peut alors procéder à l'établissement des connexions électriques entre le réseau d'interconnexion du substrat et les plots de la puce 1.

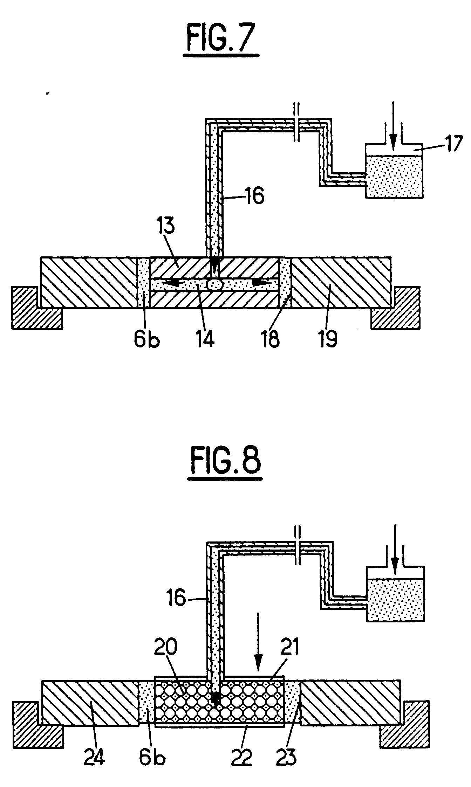

En se reportant maintenant à la figure 7, on voit que la tête d'encollage 7 de l'exemple précédent est remplacée par une tête d'encollage correspondante 13 qui, cette fois, présente des canaux d'injection 14 de matière de scellement 6b qui débouchent à sa périphérie et qui sont alimentés par un conduit d'amenée 16 relié à un réservoir 17.

Pour effectuer le dépôt de la matière de scellement 6b contre la paroi périphérique du logement 18 d'un substrat 19 correspondant au substrat 3 de l'exemple précédent, on engage la tête d'encollage 13 dans ce logement 18 de telle sorte que sa face périphérique soit en vis-à-vis de la paroi périphérique du logement 18 en laissant subsister un espace annulaire, on injecte une quantité déterminée de matière de scellement 6b dans cet espace annulaire, au travers des canaux d'injection 14 de la tête d'encollage 13, par des moyens connus non représentés placés en amont, puis on retire la tête d'encollage 13, de telle sorte qu'il subsiste une quantité déterminée de matière de scellement 6a contre la paroi périphérique du logement 18.

On procède alors à l'insertion d'une puce dans le logement 18 du substrat 19 par exemple de la même manière que dans l'exemple précédent décrit en référence aux figures 4 et 5.

En se reportant maintenant à la figure 8, on voit qu'on a représenté une autre tête d'encollage 20 qui s'utilise de la même manière que celle représentée sur la figure 7 mais qui, cette fois, est composée d'une matière poreuse disposée entre deux plaques 21 et 22, au travers de laquelle la matière d'encollage peut être injectée entre sa surface périphérique et la paroi du logement 23 d'un substrat 24 correspondant au substrat précédent.

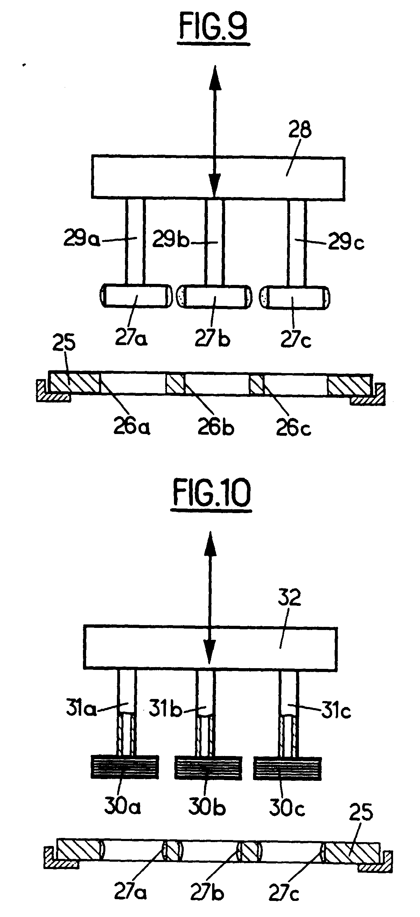

En se reportant maintenant aux figures 9 et 10, on voit qu'on a représenté un substrat 25 qui comprend trois logements traversants 26a, 26b et 26c qui sont destinés à recevoir trois puces 30a, 30b et 30c.

Pour effectuer simultanément un encollage ou dépôt de matière de scellement contre les parois des logements 26a, 26b et 26c du substrat 25, on voit sur la figure 9 qu'on a prévu trois têtes d'encollage 27a, 27b et 27c qui correspondent de préférence à l'une des têtes d'encollage 7, 13 ou 20 des exemples décrits précédemment et qui sont portées par une plaque commune mobile 28 par l'intermédiaire de bras 29a, 29b et 29c. Ces têtes d'encollage 27a, 27b et 27c sont disposées en correspondance avec les logements 26a, 26b et 26c du substrat 25 pour pouvoir y être engagées et positionnées simultanément dans ces logements de telle sorte qu'il subsiste entre leur surface périphérique et les parois des logements les espaces souhaités.

En se reportant à la figure 10, on voit que pour insérer simultanément les puces 30a, 30b et 30c dans respectivement les logements 26a, 26b et 26c, on a prévu trois têtes d'insertion 31a, 31b et 31c qui, comme dans l'exemple représenté sur les figures 4 et 5, permet de les maintenir par succion, ces têtes d'insertion 31a, 31b et 31c étant montées sur une plaque commune mobile 32. Ces têtes d'insertion sont disposées de manière à pouvoir simultanément insérer les puces 30a, 30b et 30c dans les logements 26a, 26b et 26c du substrat 25 comme dans l'exemple décrit en référence aux figures 4 et 5.

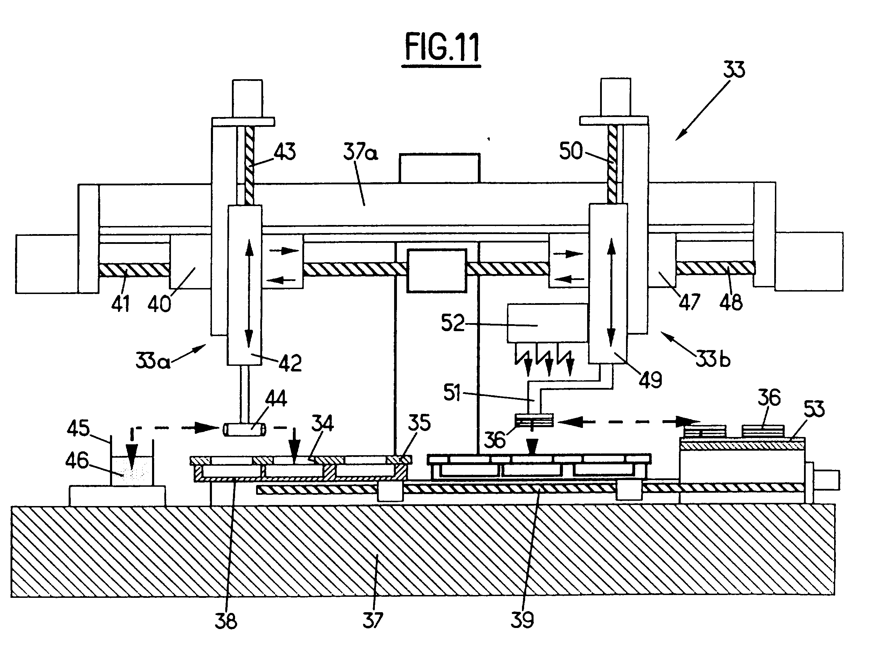

En se reportant maintenant à la figure 11, on va décrire un dispositif ou machine repéré d'une manière générale par la référence 33 qui permet l'encollage de différents logements 34 ménagés dans un substrat 35 et qui permet d'y insérer différentes puces 36.

Cette machine 33 comprend un socle 37 qui porte un chariot 38 mobile longitudinalement grâce à un système vis-écrou 39, sur lequel est posé ou fixé par tout moyen connu, horizontalement, le substrat 35.

La machine 33 comprend, au-dessus et à distance de son socle 37, un longeron horizontale 37a qui porte, sur la partie gauche de la figure 11, un mécanisme d'encollage 33a et sur sa partie droite, un mécanisme de transfert et d'insertion 33b.

Le mécanisme d'encollage 33a comprend un chariot 40 déplaçable longitudinalement sur le longeron 37a grâce à un sytème vis-écrou 41 qui porte un chariot 42 mobile verticalement grâce à un système vis-écrou 43. Ce chariot 43 porte, à son extrémité inférieure, une tête d'encollage 44 qui correspond à la tête d'encollage 7 décrite précédemment.

Sur la partie d'extrémité gauche du socle 37 est disposé un réservoir 45 qui contient de la matière de scellement 46.

Lorsque le substrat 35 est disposé grâce au système vis-écrou 39 déplaçant le chariot 38, dans la zone de déplacement horizontal de la tête d'encollage 44, on peut, en combinant le déplacement horizontal du chariot 40 et le déplacement vertical du chariot 42, déplacer la tête d'encollage 44 de manière à la plonger dans le réservoir 45 pour y prendre de la matière de scellement 46 et à l'engager dans l'un des logements 34 du substrat 35.

Le mécanisme de transfert et d'insertion 33b comprend un chariot 47 mobile longitudinalement sur le longeron 37a par l'intermédiaire d'un système vis-écrou 48 et, monté sur ce chariot 47, un chariot 49 mobile verticalement grâce à un système vis-écrou 50. Ce chariot 49 porte à son extrémité inférieure une tête d'insertion 51 équivalente à celle décrite en référence aux figures 4 et 5, ainsi qu'un émetteur de rayons ultraviolets 52.

Sur la partie droite du socle 37 est prévue une plate-forme 53 sur laquelle sont disposées les puces 36.

Lorsque le substrat 35 est disposé grâce au système vis-écrou 39 dans la zone de déplacement de la tête d'insertion 51, on peut, en combinant le déplacement horizontal du chariot 47 et le déplacement vertical du chariot 49 à l'aide respectivement des systèmes vis-écrou 48 et 50, saisir une puce 36 sur la plate-forme et, par transfert, l'amener et la disposer dans un logement 34 du substrat 35 comme on l'a décrit précédemment en référence aux figures 4 et 5, la matière de scellement étant durcie grâce à l'émetteur 52.

On peut procéder, dans une position du substrat 35, à l'encollage d'un logement 34 et, dans une autre position, à l'insertion d'une puce 36 dans ce logement, puis répéter ces opérations pour l'encollage de chaque logement et l'insertion de chaque puce. On peut également procéder à l'encollage des différents logements 34 du substrat 35 puis à l'insertion dans chacun des logements 34 des puces 36.

On pourrait par ailleurs monter à l'extrémité inférieure du chariot 42 plusieurs têtes d'encollage associées comme dans l'exemple décrit en référence à la figure 9 de manière à encoller simultanément plusieurs logements 34 du substrat 35 et monter à l'extrémité inférieure du chariot 49 plusieurs têtes d'insertion associées comme dans l'exemple décrit en référence à la figure 10 de manière à transférer et insérer simultanément plusieurs puces 36 dans les logements encollés 34 du substrat 35.

La présente invention ne se limite pas aux exemples ci-dessus décrits. Bien des variantes de réalisation et d'exécution sont possibles sans sortir du cadre défini par les revendications annexées.

## Revendications

1. Procédé d'insertion d'une puce dans un logement ménagé dans un substrat notamment du type hybride, caractérisé par le fait qu'il consiste
- à engager dans ledit logement (2) dudit substrat (3), une tête d'encollage (7) dimensionnée de telle sorte qu'il subsiste entre elle et la paroi dudit logement un espace,
- à déposer grâce à cette tête d'encollage (7) de la matière de scellement (6a) contre ladite paroi dudit logement,
- à retirer la tête d'encollage (7),
- et à placer dans ledit logement (2) ladite puce (1) de telle sorte que ladite matière de scellement déposée contre ladite paroi dudit logement remplisse au moins en partie ledit espace entre ladite paroi dudit logement et la paroi périphérique de ladite puce et que, après durcissement de ladite matière de scellement, ladite puce soit fixée audit substrat dans ledit logement.

2. Procédé selon la revendication 1, caractérisé par le fait qu'il consiste à enduire dedit matière de scellement la face périphérique de ladite tête d'encollage (7) avant de l'introduire dans ledit logement (2).

3. Procédé selon la revendication 2, caractérisé par le fait qu'il consiste à enduire dedit matière de scellement ladite tête d'encollage par trempage.

4. Procédé selon la revendication 1, caractérisé par le fait qu'il consiste à injecter ladite matière de scellement dans ledit espace entre ladite paroi dudit logement et ladite tête d'encollage (13) au travers de cette dernière.

5. Procédé selon l'une quelconque des revendications précédentes caractérisé par le fait que le durcissement de ladite matière de scellement est obtenu par traitement thermique ou par photoréticulation.

6. Procédé selon l'une quelconque des revendications précédentes, caractérisé par le fait qu'il consiste, grâce à plusieurs têtes d'encollage mobiles à effectuer les opérations précitées simultanément afin de sceller simultanément plusieurs puces dans respectivement plusieurs logements dudit substrat.

7. Procédé selon l'une des revendications précédentes dans lequel, ladite tête d'encollage (7) est dimensionnée de telle sorte qu'il subsiste entre les flancs droits dudit logement et sa paroi périphérique un espace d'épaisseur comprise entre 20 et 100 microns.

8. Procédé selon l'une des revendications précédentes dans lequel, la partie périphérique de ladite tête d'encollage (7) présentant une épaisseur égale ou inférieure à celle de la partie dudit substrat entourant ledit logement.

9. Procédé selon l'une des revendications précédentes dans lequel, ladite tête d'encollage (7) comprend au moins un canal (14) d'amenée dedit matière de scellement débouchant à sa périphérie.

10. Procédé selon l'une des revendications précédentes dans lequel, au moins la partie périphérique de ladite tête d'encollage (7) est en un matériau poreux.

11. Dispositif d'insertion de puces dans des logements (34) d'insertion ménagés dans un substrat (35) notamment du type hybride comprenant une tête d'encollage (44) pour déposer de la matière de scellement contre la paroi d'un logement dudit substrat, des moyens (33a) pour déplacer cette tête d'encollage pour l'engager dans ledit logement pour la retirer dudit logement, une tête d'insertion (51) adaptée pour engager la puce (36) dans ledit logement dudit substrat et la maintenir, et des moyens (33b) pour déplacer cette tête d'insertion.

12. Dispositif d'insertion selon la revendication 11, caractérisé par le fait qu'il comprend plusieurs têtes d'encollage et des moyens pour déplacer simultanément ces têtes afin de déposer de la matière de scellement simultanément contre la paroi de plusieurs logements du substrat, plusieurs têtes d'insertion et des moyens pour déplacer simultanément ces têtes afin d'engager et maintenir simultanément plusieurs puces dans plusieurs logements du substrat.

13. Dispositif d'insertion selon l'une des revendications 11 et 12, caractérisé par le fait que la tête d'insertion (51) transfère et maintient la puce (36) par succion.

## Patentansprüche

1. Verfahren zum Einsetzen eines Chips in eine Aufnahme, die in einem insbesondere hybridartigen Substrat vorgesehen ist, gekennzeichnet durch die folgenden Schritten:
- Hineinstecken eines Klebekopfes (7), der derart dimensioniert ist, daß er zwischen sich und der Wand der Aufnahme einen Raum läßt, in die Aufnahme (2) des Substrats (3),
- Auftragen von Versiegelungsmaterial (6a) auf die Wand der Aufnahme mittels des Klebekopfes (7),
- Zurückziehen des Klebekopfes (7) und
- Setzen des Chips (1) in die Aufnahme (2) derart, daß das auf die Wand der Aufnahme aufgetragene Versiegelungsmaterial zumindest teilweise den Raum zwischen der Wand der Aufnahme und der Umfangswand des Chips füllt und daß nach der Aushärtung des Versiegelungsmaterials der Chip am Substrat in der Aufnahme befestigt ist.

2. Verfahren gemäß Anspruch 1, gekennzeichnet durch die Tatsache, die darin besteht, daß das Versiegelungsmaterial auf die Umfangsfläche des Klebekopfes (7) aufgetragen wird, bevor er in die Aufnahme (2) eingesetzt wird.

3. Verfahren gemäß Anspruch 2, gekennzeichnet durch die Tatsache, die darin besteht, daß das Versiegelungsmaterial auf den Klebekopf durch Eintauchen aufgetragen wird.

4. Verfahren gemäß Anspruch 1, gekennzeichnet durch die Tatsache, die darin besteht, daß das Versiegelungsmaterial in den Raum zwischen der Wand der Aufnahme und dem Klebekopf (13) durch diesen letzteren hindurch eingespritzt wird.

5. Verfahren gemäß einem der vorhergehenden Ansprüche, gekennzeichnet durch die Tatsache, die darin besteht, daß die Aushärtung des Versiegelungsmaterials durch ein thermisches Verfahren oder durch Photorunzelkornbildung erreicht wird.

6. Verfahren gemäß einem der vorhergehenden Ansprüche, gekennzeichnet durch die Tatsache, die darin besteht, daß mittels mehrerer beweglicher Klebeköpfe die vorgenannten Schritte gleichzeitig bewirkt werden, um gleichzeitig mehrere Chips in entsprechend mehreren Aufnahmen des Substrats zu versiegeln.

7. Verfahren gemäß einem der vorhergehenden Ansprüche, bei dem der Klebekopf (7) derart bemessen ist, daß zwischen den aufrechten Seiten der Aufnahme und seiner Umfangswand ein Raum besteht, dessen Dicke zwischen 20 und 100 Mikrometer aufweist.

8. Verfahren gemäß einem der vorhergehenden Ansprüche, bei dem der Umfangsabschnitt des Klebekopfes (7) eine Dicke gleich der oder kleiner als die des Substratabschnitts aufweist, der die Aufnahme umgibt.

9. Verfahren gemäß einem der vorhergehenden Ansprüche, bei dem der Klebekopf (7) mindestens einen Zuleitungskanal (14) für das Versiegelungsmaterial umfaßt, der an seinem Umfang mündet.

10. Verfahren gemäß einem der vorhergehenden Ansprüche, bei dem zumindest der Umfangsabschnitt des Klebekopfes (7) aus einem porösen Material besteht.

11. Vorrichtung zum Einsetzen von Chips in Einsetz-Aufnahmen (34), die speziell in einem insbesondere hybridartigen Substrat (35) vorgesehen sind, mit einem Klebekopf (44) zum Auftragen von Versiegelungsmaterial an der Wand einer Aufnahme des Substrats, Einrichtungen (33a) zum Verschieben des Klebekopfes (7), um ihn in die Aufnahme hineinzustecken und ihn dann wieder aus der Aufnahme zurückzuziehen, einem Einsetzkopf (51), der dazu angepaßt ist, um mit dem Chip (36) in der Substrataufnahme in Eingriff zu kommen und ihn festzuhalten, und Einrichtungen (33b) zum Verschieben des Einsetzkopfes.

12. Vorrichtung zum Einsetzen gemäß Anspruch 11, gekennzeichnet durch die Tatsache, die darin besteht, daß sie mehrere Klebeköpfe und Einrichtungen zum gleichzeitigen Verschieben der Köpfe, um das Versiegelungsmaterial auf die Wand von mehreren Aufnahmen des Substrats gleichzeitig aufzutragen, mehrere Einsetzköpfe und Einrichtungen zum gleichzeitigen Verschieben der Köpfe umfaßt, um gleichzeitig mit mehreren Chips in mehreren Substrataufnahmen in Eingriff zu kommen und sie festzuhalten.

13. Vorrichtung zum Einsetzen gemäß Anspruch 11 oder 12, gekennzeichnet durch die Tatsache, die darin besteht, daß der Einsetzkopf (51) den Chip (36) durch Ansaugen überführt und festhält.

## Claims

1. Method for the insertion of a chip into a housing let into a substrate especially of the hybrid type, characterised by the fact that it consists
- in engaging in the said housing (2) in the said substrate (3) an adhesive application head (7) dimensioned such that between it and the wall of the said housing there remains a space,
- in depositing sealing material (6a) against the said wall of the said housing by virtue of this adhesive application head (7),
- in withdrawing the adhesive application head (7),
- and in placing the said chip (1) in the said housing (2) in such a way that the said sealing material deposited against the said wall of the said housing at least partially fills the said space between the said wall of the said housing and the peripheral wall of the said chip and that, after hardening of the said sealing material, the said chip is fixed to the said substrate in the said housing.

2. Method according to Claim 1, characterised by the fact that it consists in coating the peripheral face of the said adhesive application head (7) with said sealing material before introducing it into the said housing (2).

3. Method according to Claim 2, characterised by the fact that it consists in coating the said adhesive application head with said sealing material by immersion.

4. Method according to Claim 1, characterised by the fact that it consists in injecting the said sealing material into the said space between the said wall of the said housing and the said adhesive application head (13) through this latter.

5. Method according to any one of the preceding claims, characterised by the fact that the hardening of the said sealing material is brought about by thermal treatment or by photoreticulation.

6. Method according to any one of the preceding claims, characterised by the fact that it consists, by virtue of several moveable adhesive application heads, in effecting the abovementioned operations simultaneously in order to simultaneously seal several chips into respectively several housings in the said substrate.

7. Process according to one of the preceding claims, in which the said adhesive application head (7) is dimensioned such that between the straight sides of the said housing and its peripheral wall there remains a space of thickness lying between 20 and 100 microns.

8. Process according to one of the preceding claims, in which the peripheral part of the said adhesive application head (7) exhibiting [sic] a thickness equal to or less than that of the part of the said substrate surrounding the said housing.

9. Process according to one of the preceding claims, in which the said adhesive application head (7) comprises at least one supply channel (14) for said sealing material opening out at its periphery.

10. Process according to one of the preceding claims, in which at least the peripheral part of the said adhesive application head (7) is in a porous material.

11. Device for the insertion of chips into insertion housings (34) let into a substrate (35) especially of the hybrid type, comprising an adhesive application head (44) for depositing sealing material against the wall of a housing in the said substrate, means (33a) for moving this adhesive application head for engaging it in the said housing for withdrawing it from the said housing [sic], an insertion head (51) adapted in order to engage the chip (36) in the said housing in the said substrate and to hold it, and means (33b) for moving this insertion head.

12. Insertion device according to Claim 11, characterised by the fact that it comprises several adhesive application heads and means for simultaneously moving these heads in order to deposit sealing material simultaneously against the wall of several housings in the substrate, several insertion heads and means for simultaneously moving these heads in order to simultaneously engage and hold several chips in several housings in the substrate.

13. Insertion device according to one of Claims 11 and 12, characterised by the fact that the insertion head (51) transfers and holds the chip (36) by suction.
